Europäisches Patentamt

**European Patent Office**

**Office européen des brevets**

(11) Publication number: **0 116 289**

**A2**

(12) # EUROPEAN PATENT APPLICATION

(21) Application number: **84100253.8**

(22) Date of filing: **12.01.84**

(51) Int. Cl.³: **H 01 L 23/36**
**H 01 L 23/04, H 01 L 25/04**

(30) Priority: **12.01.83 US 457468**

(43) Date of publication of application:
**22.08.84 Bulletin 84/34**

(84) Designated Contracting States:
**DE FR GB**

(71) Applicant: **Allen-Bradley Company**
**1201 South Second Street**
**Milwaukee Wisconsin 53204(US)**

(72) Inventor: **Frey, Sydney W.**
**2880 Smith Drive**
**Brookfield Wisconsin 53005(US)**

(72) Inventor: **Berman, Albert H.**
**2127 Redondela Drive**
**San Pedro California 90732(US)**

(74) Representative: **Lippert, Hans, Dipl.-Ing. et al,**
**Reichel und Reichel Parkstrasse 13**
**D-6000 Frankfurt (Main) 1(DE)**

(54) **Power semiconductor module and package.**

(57) An improved power semiconductor module (12a, 12b) includes a semiconductor die (14) which typically embodies a power semiconductor die such as a transistor or Darlington transistor pair thereon. The die (14) is fastened by solder bonding to the top side of an electrically conductive supporting plate (16) which has approximately the same thermal co-efficient of expansion as the die itself. Overlying the die (14) is a ceramic cover (18) whose lower edges (20) are typically metallized for solder bonding to the supporting plate (16) to obtain a hermetic seal about the die. Solder bond electrical connection to the top side of the die (14) is facilitated by electrodes (22, 24) which extend through passageways (21a 21b) in the ceramic die cover (18) for contact with the die. Each of the electrodes (22, 24) extending through the ceramic die cover (18) is typically solder bonded to the cover so that mechanical and thermal stresses are transmitted to the ceramic die cover (18) and not to the die (14). The ceramic die cover (18) not only protects the die (14) from mechanical and thermal stress, but also facilitates manufacturing of the semiconductor module (12a 12b) as the ceramic die cover (18) acts as an alignment and support fixture for the electrodes (22, 24) during assembly.

FIG.I

## Power semiconductor module and package

This invention relates generally to discrete power semiconductors, such as transistors, diodes, and thyristors. More particularly, this invention relates to an improved semiconductor package which seals the semiconductor die from the ambient atmosphere as well as protecting the die from thermal and mechanical stresses while allowing for solder-bonded junctions to achieve ease of manufacturing.

Present day semiconductors, and especially present day power semiconductors, are generally comprised of a semiconductor chip or die which may embody a diode, a transistor, a thyristor or any combination thereof. To protect the die, the semiconductor die is enclosed within a housing. The housing or case as is referred to in the art, is usually metal, plastic or ceramic. In the past, the connection between the die and a terminal bus on the case has been accomplished by jumper wires. The jumper wires are each welded to one of the connectors of the terminal bus and then the jumper wires are aligned manually with the corresponding termination pads on the die. Once alignment is completed, each of the jumper wires is ultrasonically welded to the corresponding termination pad on the die.

While for the most part present day power semiconductors constructed in this fashion are satisfactory, such power semiconductor constructions results in several disadvantages. Although the thin jumper wire loop created by joining the jumper wire to the die and to the terminal bus serves to reduce the thermal stress on each connection, the jumper wire connection is nonetheless relatively fragile. Moreover, welding the jumper wire to the die results in some degradation to the die surface and thus extreme quality control is required to maintain reliability of the device. In addition, when each jumper wire is ultrasonically welded to a corresponding termination pad on the die, only a relatively small portion of the area of the termination pad is in actual electrical contact with the jumper wire. The small area of connection tends to increase the resistance of the current path between the die and the terminal bus which is very undesirable in a power semiconductor device.

Prior art semiconductors packages which utilize metal and ceramic cases generally suffer from many design limitations, not to mention high material costs and high fabrication costs. In an effort to reduce semiconductor packaging costs, many semiconductor manufacturers have begun to package the die within a plastic case. While plastic cases are less expensive and easier to fabricate, generally, a hermetic seal cannot be obtained with a plastic case and thus, the junctions between the jumper wires and the die and the jumper wires and the terminal bus are thus difficult to protect. A hermetic seal is generally desirable since such a seal prevents contaminants from entering the package. In addition, plastic semiconductor cases do not generally provide good protection against thermal and mechanical stresses.

The present invention concerns a low cost, easy to fabricate semiconductor package which achieves good thermal and mechanical stress protection while achieving reduced material and fabrication costs. The core of the improved semiconductor package of the present invention comprises a module which includes a semiconductor die mounted to a mounting plate having the same thermal expansion characteristics as the die itself. Typically, the mounting plate is a molybdenum substrate. A ceramic die cover, having a recess therein, is secured to the mounting plate, either by solder bonding or by polymer sealant, to overlie the die. One or more conductive members, referred to as electrodes, each extend through separate openings in the cover for solder bonding the termination pads on the die. In practice, the openings in the die cover are metallized and coated with solder and so too the electrodes are coated with solder so that during a solder reflow operation, the electrodes become solder bonded to the die cover, thereby assuring good thermal and mechanical stress protection. This semiconductor module may be mounted directly to a printed circuit board. Alternatively, the module may be enclosed within a housing configured of a heat conductive base plate and a plastic shell overlying the base plate to encapsulate the module.

The present invention provides an semiconductor package which protects the semiconductor die against thermal and mechanical stresses and additional supports and aligns the top side solder connections to the die. This is accomplished in the present invention by supporting the die from a plate and enclosing the semiconductor die within the recess of the ceramic die cover secured to the plate. One or more electrodes are fastened to and extend through the semiconductor die cover for electrical contact with the die. The mechanical connection between the electrodes and the die cover assures that thermal and mechanical stresses are transmitted through the electrode to the die cover and not the die. The die cover is typically a very high temperature material such as ceramic which has a thermal coefficient of expansion similar to the die itself so as to easily withstand high soldering temperatures and thereby minimize thermal stress to the die.

Further, the present invention provides semiconductor package which is simple and inexpensive to fabricate. The ceramic die cover of the semiconductor package of the present invention achieves alignment of the top side solder connections to the die without the need for additional fixturing or tedious manual effort thereby reducing fabrication costs. Moreover, the ceramic die cover is readily solder bonded to the mounting surface at the same time the electrode connections to the die are achieved during a solder-reflow operation which also reduces fabrication costs.

Other objects and advantages of the present invention will become apparent upon review of the following specification.

The invention both as to organisation and method of operation together with further objects and advantages thereof may best be understood by reference to the following description taken in conjunction with the accompanying drawings in which:

Fig. 1 is a cutaway perspective view of a first preferred embodiment of the improved semiconductor package of the present invention whose electrodes feed directly into the ceramic die cover for contact with the die surface;

Fig. 2 is an end view of the semiconductor package illustrated in Fig. 1;

Fig. 3 is an exposed frontal elevational view of an alternate preferred embodiment of the improved semiconductor package of the present invention which utilizes feed pins swaged through the ceramic die cover for contact with the surface of the die;

Fig. 4 is a cross sectional view of the semiconductor package of Fig. 3 taken along lines 4-4 thereof;

Fig. 5 is a cross-sectional view of the semiconductor package of Fig. 3 taken along lines 5-5 thereof;

Fig. 6 is a cutaway elevational view of a portion of the semiconductor package of Figures 1 and 2 illustrating the mounting of the die embodying the speed up diode;

Fig. 7 is an exposed frontal elevational view of an improved semiconductor surface mount module whose electrodes are swaged into the ceramic die cover for connection to the die; and

Fig. 8 is a frontal elevational view of the surface mount module of Fig. 6 illustrating a stamping attached thereto for terminal pin connection to the bottom and having heat dissipating fins for heat dissipation.

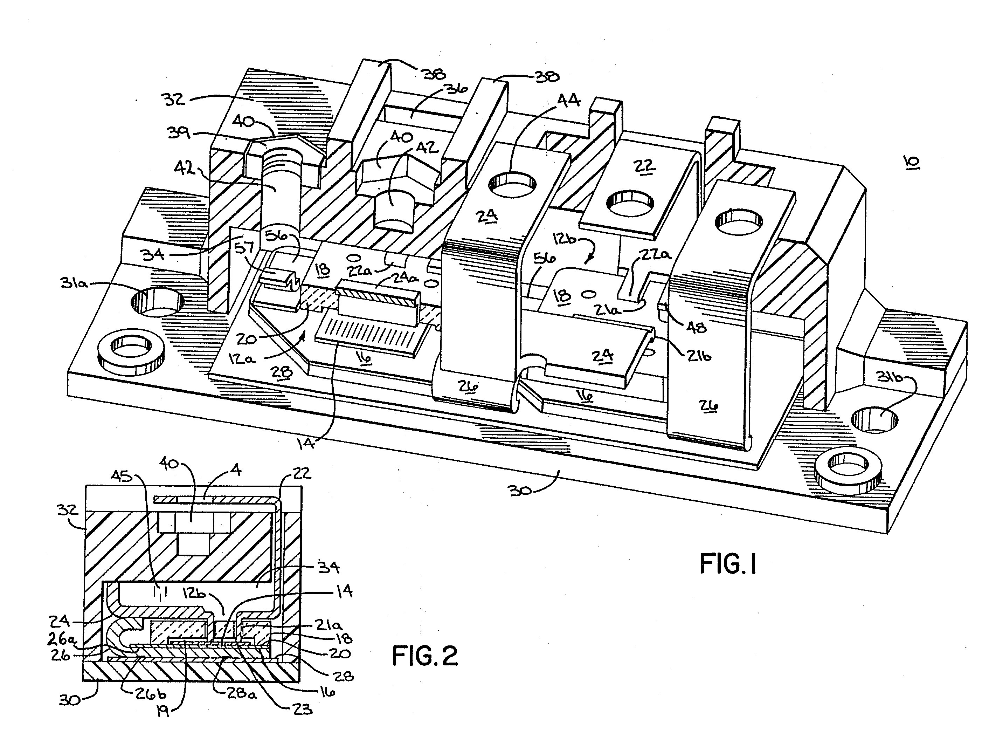

Figures 1 and 2 illustrate the preferred embodiment 10 of an improved power semiconductor package. In the presently preferred embodiment, power semiconductor package 10 incorporates two power semiconductor modules 12a and 12b although a lesser or greater number of modules may be incorporated within power semiconductor package 10 without departing from the spirit or scope of the present invention. Semiconductor modules 12a and 12b, which are at the core of the present invention, are each identical and therefore, only module 12a will be described in detail with like reference numbers being utilized to identify the like elements of the module 12b. Semiconductor module 12a comprises a semiconductor die 14 which embodies a semiconductor device. Although the semiconductor device embodied on die 14 may take the form of a single transistor, a diode, or a thyristor, die 14 preferably embodies a Darlington transistor pair having first and second stage transistor elements (not shown). Die 14 is supported from, and is mounted to, a supporting plate 16 which is of an area significantly larger than the area of the die itself. Mounting plate 16 takes the form of a metallic substrate of molybdenum or the like so that the thermal co-efficient of expansion of plate 16 is approximately equal to the thermal expansion of die 14. Selecting the thermal co-efficient of expansion of mounting plate 16 approximately equal to that of die 14 reduces the likelihood of separation of the die from the plate at high temperatures. To secure die 14 to the molybdenum plate 16, the top and bottom surfaces of the molybdenum plate 16 are coated with solder. Typically, the solder coating of plate 16 is accomplished by cladding techniques. The bottom side of die 14 is metallized for solderability so that during a solder-reflow operation, the die 14 is electrically and mechanically · bonded to plate 16.

Overlying the die 14 is a ceramic die cover 18 having a recess 19 (Figure 2) dimensioned to receive the die 14. To secure the die cover 18 to plate 16, the bottom edges 20 of the die cover 18 are metallized with a metallic alloy, coating typically a mixture of molybdenum and manganese. The metallization on the lower edges 20 of the die cover 18 is nickel plated for solder bonding to the top side of the plate 16 during a solder-reflow operation. Although ceramic die cover 18 can be constructed of different types of ceramic material, in practice, it is desirable to construct ceramic die cover 18 of a very high grade ceramic material such as 96% Alumina.

Unlike the conventional power semiconductors which utilize ultrasonically bonded jumper wires to obtain external connection to the die, the semiconductor modules of the present invention each employ relatively thick terminals or electrodes to accomplish an electrical connection between the die 14 and external devices. Referring now to Figs. 1 and 2 jointly, with the semiconductor die 14 of each semiconductor module embodying a Darlington power transistor, the ceramic die cover 18 of the semiconductor module, such as module 12b is provided with a pair of rectangular passages 21a and 21b. Each passage is dimensioned to receive a separate one of the fingers 22a and 24a of electrodes 22 and 24, respectively. Electrodes 22 and 24 are designated as the base and emitter electrodes, respectively, as each extends through a separate one of openings 21a and 21b to contact the base connection pad (not shown) of the first stage transistor element and the emitter connection pad (not shown) of the second stage transistor element, respectively, on the die. As may be appreciated by reference to Fig. 2, the bottom edge of each of the electrode fingers such as base electrode finger 22a for example, has a solder coating 23. The base and emitter connection pads on the die are also solder coated so that during the solder-reflow operation, the base and emitter electrode fingers electrically bond to the base and emitter connection pads, respectively, on the die. In addition to the electrode fingers being solder-bonded to the die, each of base and emitter electrodes 24 is also solder-bonded to the die cover 18. Such bonding is accomplished by solder coating electrode fingers 22a and 24a of electrodes 22 and 24 and by metallizing and solder coating the contact surfaces of openings 21a and 21b of die cover 18. Thus, during a solder-reflow operation, not only will the fingers 22a and 24a of electrodes 22 and 24 become bonded to the die 14 but also the electrode fingers become bonded to the die cover 18 as well.

The die cover 18 of each of semiconductor modules 12a and 12b serves two very important functions. Firstly, the die cover 18 serves to greatly reduce the amount of mechanical and thermal stresses transmitted by each of the electrodes 22 and 24 to the die 14. Mechanical and thermal stresses applied to either of electrodes 22 and 24 are transmitted to die cover 18 rather than to die 14 by virtue of the bonding of the electrode to the die cover 18. In addition, openings 21a and 21b in die cover 18 serve as alignement guides for aligning electrode fingers to the top side connection pads of die 14, eliminating the need for additional fixtures or tedious manual effort.

Die 14 of each of semiconductor modules 12a and 12b is typically manufactured by Mesa techniques so that the collector connection pad (not shown) is on the bottom or under surface of die 14 as opposed to the emitter and base connection pads (not shown) which appear on the top side of the die. Thus, when semiconductor die 14 is solder-bonded to molybdenum plate 16, the molybdenum plate 16 becomes electrically connected to the collector pad (not shown) on the die.

An electrical connection between the collector connection pad and external device is accomplished via a right angle collector electrode 26. Referring to Fig. 2, the upper horizontal surface 26a of collector electrode 26 is solder-coated as is the bottom or under surface of plate 16 of the module so that during a solder-reflow operation, the collector electrode 26 bonds to the plate 16 of the module. In instances where a pair of Darlington power transistor modules, such as modules 12a and 12b are incorporated in a single semiconductor package, such as package 10 of the present embodiment, it is desirable that the collector electrode 26 of module 12a be solder-bonded to the emitter electrode 24 of module 12b to reduce the overall length of package 10.

Unlike the relatively thin jumper wires of prior art semiconductor packages, each of collector and emitter electrodes 24 and 26 of semiconductor modules 12a and 12b comprises a 0.15mm (0.062 inch) thick nickel plated copper strip for providing a low resistance circuit path. The base electrode 22 of each of modules 12a and 12b comprises a 0.075mm (0.031 inch) thick nickel plated copper strip. Since the base electrode of each semiconductor module carries much less current than the collector and emitter electrodes 26 and 24, respectively, base electrode 22 of each module can be manufactured of a thinner copper strip without adversely impairing the current rating of the semiconductor module.

In the presently preferred embodiment of power semiconductor package 10, illustrated in Figures 1 and 2, modules 12a and 12b each have their collector electrodes bonded to a ceramic subplate 28 which is of a surface area greater than the combined surface area of plates 16 of modules 12a and 12b. Referring to Fig. 2, the under surface 26b of collector electrode 26 of each module is coated with solder and the upper surface 28a of ceramic subplate 28 is metallized, that is coated with a mixture of manganese and molybdenum and the metal coating (not shown) coated with solder to enable solder-bonding of the collector electrode 26 to the ceramic subplate 28 during a solder-reflow operation. In practice, ceramic subplate 28 is comprised of a pad of Alumina ceramic material.

Ceramic subplate 28 is supported by a copper base plate 30 which is typically 0.3175mm (0.125 inches) thick. The upper surface of base plate 30 is solder-coated. The under surface of ceramic subplate 28 is metallized and is solder-coated so that during a solder-reflow operation, the copper plate 30 becomes bonded to the ceramic subplate which is bonded to collector electrodes 26 of modules 12a and 12b. The ceramic subplate 28 does not act as an electrical conductor and thus collector electrodes 26 of modules 12a and 12b are isolated from the copper base plate. Although the ceramic subplate is not an electrical conductor, the ceramic subplate nevertheless conducts heat from each of the semiconductor modules 12a and 12b to the copper base plate 30 which dissipates the heat to the environment. Referring to Fig. 1, copper base plate 30 is provided with a pair of mounting passages 31a and 31b, one at each end thereof. In practice, the distance between mounting passages is made 80mm so that the power semiconductor package 20 of the present invention can be utilized in place of present day power semiconductor packages having 80mm mounting centers.

The semiconductor modules 12a and 12b are encapsulated by a plastic housing 32 having an interior recess 34 dimensioned to receive both modules when the plastic housing 34 is fastened to base plate 32 to overlie the modules. Plastic housing 32 is provided with separate, spaced apart passages 36 (only one of which is illustrated in Figures 1 and 2) so that the collector, base and emitter electrodes 26, 22 and 24, respectively, of module 12b and the base and emitter electrodes (not shown) of module 12a may extend upwardly through the housing for electrical connection to external circuit components. In practice, the protruding portion of each electrode, such as the protruding portion of electrodes 22, 24 and 26 of module 12b are bent over, at approximately 90° to overlie the upper surface of plastic housing 32. Separating each adjacent pair of electrodes is a separate one of protruding ribs 38 which extend upwardly from the top of housing 32.

Before each electrode is bent over to overlie the upper surface of housing 32, hexagonal nuts 39 (only one of which is shown in Fig. 1) are each pressed into a separate one of hexagonal apertures 40 molded into the top surface of housing 32 to underlie a separate one of the electrodes of each of modules 12a and 12b. Each hexagonal passageway 40 communicates with a counter bore 42 to receive a portion of the shaft of a machine screw shaft (not shown) when the machine screw is inserted through a passageway 44 in the electrode for threaded engagement with the hexagonal nut 39. Note that the counterbore 42 of the hexagonal passageway 40 located at the opposite ends of the top of housing 32 extend through the housing into recess 34 whereas the inwardly spaced counterbores 42 do not. Extending the counterbore 42 of the outermost one of hexagonal passageways 40 into the recess allows potting compound 45 to be entered into the housing recess and vented through the other fully extending counterbore.

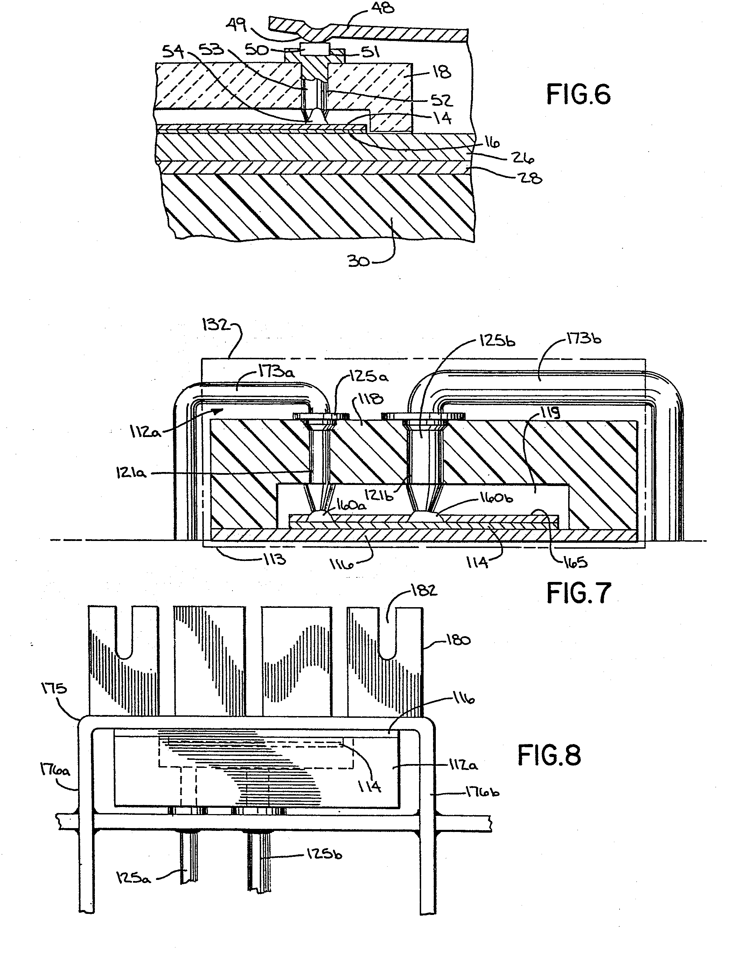

When a Darlington power transistor embodied on the die 14 of each semiconductor module of power semiconductor package 10, it is generally desirable to shunt the base-emitter junction of the first stage transistor element of the power Darlington transistor with an oppositely poled diode. This diode is usually referred to as speed-up diode because the diode improves power transistor switching speed. Such a diode may be advantageously incorporated with each module as follows. Referring jointly to Figures 1 and 6, the base electrode of each module such as base electrode 22 of module 12b is provided with a second finger 48 in addition to finger 22a. The base electrode finger 48 overlies ceramic die cover 18 so as to be approximately equidistant from the edges of the semiconductor die within die cover 18. In this way, base electrode finger 48 will overlie the emitter region (not shown) of the first stage transistor of the Darlington power transistor embodied on die 14.

Referring now to Fig. 6, underlying a depressed area 49 on electrode finger 48 is a semiconductor die 50 which is seated in the recess 51 of a rivet 52 which extends through an opening 53 in the die cover 18 to contact die 14. The lowermost end of the rivet 52 is solder-coated for bonding to a solder pocket 54 on the die 14 in electrical connection with the emitter of the first stage Darlington transistor element on the die 14. Semiconductor die 50 is solder-coated on its upper and lower surfaces for bonding to the rivet 52 and the under surface of the depressed area 49 on base electrode finger 48 during a solder-reflow operation. The shank of the rivet 52 of Fig. 6 is coated with solder as is the metallized contact surfaces of the die cover rivet-receiving passageway 53. Thus, when the rivet and die cover are heated during a solder-reflow operation, rivet 52 becomes solder-bonded to the die cover. Note that the spring force of the base electrode finger 48 keeps semiconductor die 50 within the rivet recess 51 to simplify assembly.

In addition to shunting the first stage transistor element of the Darlington transistor on die 14 with a speed-up diode, it is also desirable to shunt the collector-to-emitter portion of the second stage transistor element of the Darlington transistor with a freewheeling diode. The freewheeling diode provides a reverse-conductive path across the collector-to-emitter portion of the second stage transistor to prevent damage as a result of inverse inductive current as may occur when the Darlington transistor is utilized to power inductive loads. Referring to Fig. 1, the molybdenum plate 16 of each module, such as module 12a, mounts a semiconductor die 56 embodying the freewheeling diode. The anode connection pad (not shown) on the under surface of die 56 is solder-coated as is the upper surface of the area of the plate 16 underlying die 56 so that during a solder-reflow operation, die 56 is bonded to the plate 16 to assure a firm electrical connection between the anode of the freewheeling diode embodied on die 56 and the collector of the second stage transistor element of the Darlington transistor embodied on die 14.

To establish a connection between the emitter of the second stage transistor element of the Darlington transistor embodied on die 14 of each module, such as module 12b, the emitter electrode of the module, such as electrode 24 of module 12b, is provided with a second finger 57 which extends from the electrode to overlie die 56. The cathode connection pad (not shown) of the diode on die 56 and the underside of finger 57 of the emitter electrode 24 are both solder-coated so that during a solder-reflow operation, the emitter electrode finger 57 bonds with the cathode connection pad on die 56 to assure a firm mechanical and electrical connection therebetween.

The above described construction of semiconductor package 10 affords several advantages over prior art semiconductor packages. Firstly, each of the power semiconductor modules 12a and 12b can be easily assembled using solder reflow techniques thereby effecting a savings of assembly time. Moreover, in addition to relieving mechanical and thermal stresses applied to die 14 of each module, the ceramic die cover 18 also serves to align the electrodes which further reduces the assembly effort.

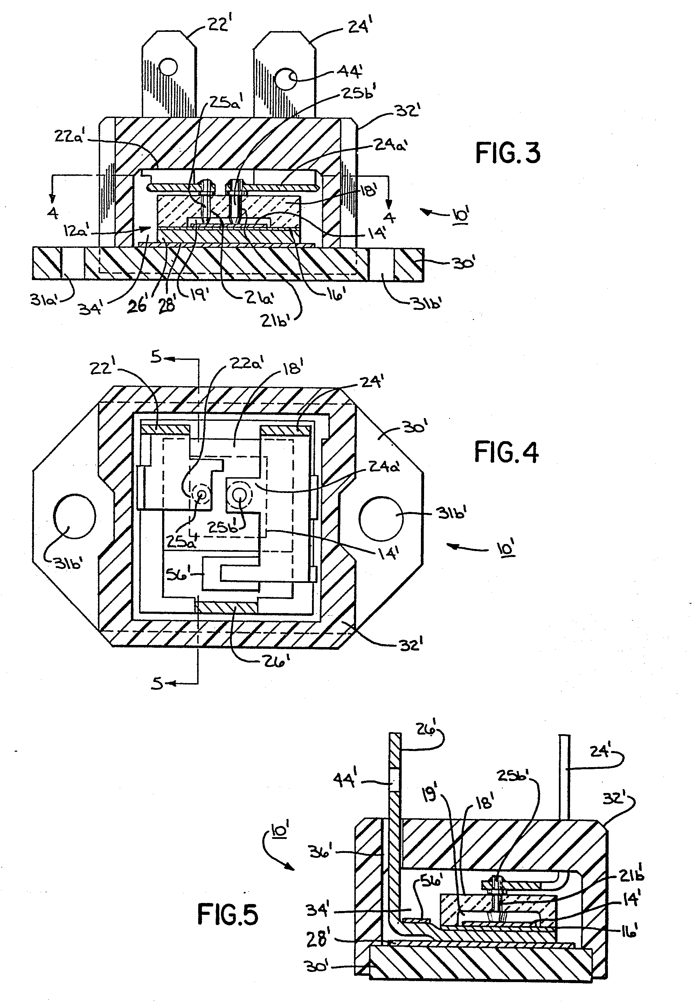

Figures 3, 4 and 5 are cutaway front, plan and side views of an alternate preferred embodiment of a semiconductor package 10'. Semiconductor package 10' is in most respects similar to semiconductor package 10 except that semiconductor package 10' contains but a single semiconductor module 12a' in contrast to the two modules 12a and 12b within semiconductor package 10. Module 12a' is very similar in construction to modules 12a and 12b of Figures 1 and 2 and includes a semiconductor die 14' electrically bonded, by soldering-reflow techniques, to a molybdenum plate 16'. Overlying the die 14' is a ceramic die cover 18' which has a recess 19' therein dimensioned to receive the die 14' after the die cover is secured to the plate 16' overlying die 14'. Typically, the lower edges of the die cover 18' are metallized and solder-coated so that the die cover 18' can be secured to plate 16' by a solder bond in the manner described previously with respect to Figures 1 and 2. However, in certain applications when a hermetic seal between the die cover 18' and the plate 16' is not necessary, a polymer sealant may be employed to bond the ceramic die cover to the molybdenum plate 16'.

The major difference in the construction of semiconductor module 12a' of power semiconductor package 10' of Figures 3 to 5 and the construction of modules 12a and 12b of power semiconductor package 10 of Figures 1 and 2, is the manner in which the base and emitter electrodes make contact with the base and emitter connection pads (not shown) on the semiconductor die. As will be recalled, the base and emitter electrodes 32 and 24 of each module of Fig. 1, such as module 12b for example, are provided with fingers 22a and 24a, respectively, which extend through passages 21a and 21b of die cover 18 for contact with die 14. In contrast, the base and emitter electrodes 22' and 24' of the semiconductor module 12a' of Figures 3 to 5 do not themselves physically contact the die. Instead, a pair of pins 25a' and 25b' are each swaged through circular openings 21a' and 21b', in the die cover 18'. Each of the fingers 22a' and 24a' of base and emitter of electrodes 22' and 24', respectively, has an aperture which is dimensioned to receive protruding portion of a separate one of pins 25a' and 25b'. Each of pins 25a' and 25b' is solder-coated as is the pin-receiving aperture in each of electrode fingers 22a' and 24a' respectively. In addition, the contact surfaces of openings 21a' and 21b' in die cover 18' are metallized and solder-coated so that during a solder-reflow operation, pins 25a' and 25b' bond to a corresponding one of electrode fingers 22a' and 24a' as well as to the metallized and solder-coated contact surfaces of openings 21a' and 21b' in die cover 18'. Additionally, the base and emitter connection pads (not shown) of die 14' are also solder coated for electrical bonding to the bottom tips of pins 25a' and 25b' during a solder-reflow operation.

As with the die 14 of each of modules 12a and 12b of Fig. 1, the die 14' of module 12a' of Figures 3 to 5 is manufactured by the Mesa techniques so that the collector connection pad (not shown) is on the bottom surface of the die 14' as opposed to the base and emitter connection pads which appear on the top side of the die 14'. To achieve an electrical connection with the collector connection pad of the die 14', the plate 16' of module 12a' is mounted on the upper surface of the horizontal leg of collector electrode 26' of Fig. 5. Typically, the collector electrode horizontal leg member is solder coated as is the lower surface of molybdenum plate 16' so that a solder bond therebetween is achieved during a solder-reflow operation.

The module 12a' of semiconductor module 10' thus far described essentially differs from modules 12a and 12b of package 10 of Figures 1 and 2, in that swaged pins 25a' and 25b' are utilized to make the connection with the die 14' rather than the electrode fingers. Otherwise, the construction of modules is identical.

Module 12a' is packaged in an outer housing in much the same way modules 12a and 12b of package 10 are housed. The undersurface of collector electrode 26' is mounted on the upper surface of a ceramic subplate 28'. Underlying the subplate 28' is a copper base plate 30'. The upper and lower surfaces of the ceramic subplate 28' are each metallized and solder-coated as is the undersurface of the collector electrode 26' and the upper surface of the copper base plate 30'. Thus during a solder-reflow operation, the electrode, the ceramic subplate and the base plate bond to one another. Although the top and bottom surfaces of ceramic subplate 28' are metallized, the ceramic subplate 28' electrically isolates the collector electrode 26' from base plate 30'. However, ceramic subplate 28' serves to carry heat from the collector electrode 26' to the base plate 30' which in turn dissipates the heat to the environment. To facilitate mounting, base plate 30' has a pair of mounting passages 31a' and 31b' as best illustrated in Figures 3 and 4.

A plastic housing 32' has a recess 34' therein dimensioned to receive module 12a' when the housing 32' is secured to base plate 30' to overlie the module 12a'. A separate one of passages 36' are provided in housing 32' to enable a separate one of electrodes such as electrode 26' to extend through the housing 32'. Unlike the electrodes of power semiconductor package 10 which are bent over the upper surface of the housing, the electrodes 22', 24' and 26' of power semiconductor package 10' extend substantially vertically beyond the plastic housing 32'. Each electrode has an aperture 44' disposed therethrough to facilitate electrical connection between the electrode and a connecting bus bar (not shown).

As with each of modules 12a and 12b of power semiconductor package 10 of Figures 1 and 2, module 12a' of power semiconductor package 10' includes a speed up diode which is embodied on a semiconductor die (not shown). The semiconductor die underlies a finger 48' on the base electrode 22'. Both the finger 48' and the anode connection pad (not shown) on the upper surface of the die are solder-coated so that during a solder-reflow operation, a firm solder bonding therebetween is accomplished. Underlying the die is a rivet (not shown) which extends through ceramic die cover 18' for physical contact and electrical connection with the emitter connection pad (not shown), of the first stage of the Darlington transistor embodied on die 14'. The mounting of the die between the finger 48' of the base electrode 22' and the rivet is identical to that described previously for semiconductor die 50 of Fig. 6. In addition, the semiconductor module 12a' also embodies a freewheeling diode which takes the form of a semiconductor die 56' mounted between the collector electrode 26' of the module 12a' and a second finger on the emitter electrode 24' (not shown).

The use of swaged feedthrough pins for connecting each of the fingers 22a' and 24a' of the base and emitter electrodes 22' and 24' respectively to the base and emitter connection pads on die 14' enables reduced production costs as compared to the production costs associated with the power semiconductor module 10. The swaged feedthrough pins can be stamped into the ceramic die cover very readily at very low cost so that the ceramic die cover and the swaged feedthrough pins become a single assembly. The assembly of the swaged feedthrough pins and the ceramic die cover assures a better electrical connection between the swaged feedthrough pins and the die than that is accomplished by the electrode fingers of semiconductor package 10 of Figures 1 and 2.

The semiconductor packages 10 and 10' described thus far have included a copper mounting pad (30 and 30', respectively) and a ceramic subplate (28 and 28', respectively) for mounting the semiconductor module and a plastic housing (32 and 32', respectively) for enclosing the module. In certain instances it may be desirable to utilize the semiconductor module by itself for surface mounting to a printed circuit board. Referring to Fig. 7 there is shown a surface mount power semiconductor module 112a which may be mounted to a printed circuit board 113. Surface mount semiconductor module 112b is similar in construction to semiconductor modules 12a and 12a' described previously with respect to Figures 1 and 2 and Figures 3 to 5, respectively, and includes a semiconductor die 114. The semiconductor die 114 embodies a semiconductor such as a transistor, a diode, or a thyristor or any combination of diodes, transistors and thyristors. The die 114 is supported from a mounting pad 116 having approximately the same thermal coefficient of expansion as the die itself. In practice, the supporting pad 116 takes the form of a molybdenum substrate having solder-coated top and bottom surfaces. During a solder-reflow operation, the bottom surface of the die 114, which is solder-coated, becomes solder bonded to the top surface of the supporting plate 116.

A ceramic die cover 118 is provided with a recess 119 therein dimensioned to receive the die 114 and the die cover is mounted to plate 116 to overlie the die 114. In practice, the lower edges of the ceramic die cover 118 are metallized and solder-coated for solder bonding to the top surface of the molybdenum supporting plate 116 during a solder-reflow operation. The ceramic die cover 118 has a pair of passageways 121a and 121b whose contact surfaces are each metallized and solder coated. Each of die cover passageways 121a and 121b receives a separate one of base and emitter pins 125a and 125b which are swaged through the die cover. The portion of each of the pins 125a and 125b in contact with the die cover passages 121a and 121b is solder-coated to enable bonding of the pin to the die cover during a solder-reflow operation. The protruding tip of each of pins 125a and 125b is also solder-coated to enable solder bonding to the pads 160a and 160b on die 114. Typically, pads 160a and 160b are formed on the die by coating the die with a polymer sealant 165 so as to leave the two pads 160a and 160b exposed for solder coating during the silk screening process or afterwards.

The cold swaging of each of pins 125a and 125b into the ceramic die cover and the subsequent solder bonding of the pins to the die cover assures that the pins are firmly held in the die cover. In this way, the pins transmit thermal and mechanical stresses to the die cover 118 and to mounting plate 116 rather than to the die itself. The ceramic die cover 118, in addition to carrying the thermal and mechanical stresses applied to pins 125a and 125b to mounting plate 116, also sealably encloses the die to prevent exposure to contaminants.

As with each of the semiconductor dies 14 and 14' of Figures 1 and 2 and Figures 3 to 5, the semiconductor die 114 of module 112a is manufactured by Mesa techniques so that the collector connection pad (not shown) of the die 114 is electrically connected to the molybdenum supporting plate 116 by virtue of the solder bonding of the die to the molybdenum supporting plate. Thus, when the module 112a is mounted on a printed circuit board such as printed circuit board 113 so that the molybdenum pad 116 overlies a conductive circuit board foil (not shwon) the underlying printed circuit board foil is thus in electrical contact with the collector of the transistor on the die 114. To facilitate connection between each of pins 125a and 125b which protrude from the top of the ceramic die cover 118, and conductive foils (not shown) on the surface of circuit board 113, extended member 173a and 173b of pins 125a and 125b are each bent outward and downward to the corresponding one of the conductive foils (not shown) on circuit board 113.

To protect module 112a, the module may be enclosed within a plastic shell 132 (as shown in phantom) to shield the module against contaminants and corrosives.

In certain instances, it is desirable to provide for greater heat dissipation of surface mount module 112a. Referring now to Fig. 8, in instances where greater heat dissipation is desired, the semiconductor surface mount module 112a is inverted so that molybdenum plate 116, which now appears at the top of the module, can be bonded to the bottom of the interior surface of the web section of a U-shaped copper stamping 175. The legs 176a and 176b of the stamping 175 extend downwardly into the circuit board for solder bonding to separate conductive foils on the circuit board. Each of the legs 176a and 176b of the stamping 175 not only serves to secure the stamping to the circuit board, but also serve as a collector connection path by virtue of the solder connection of the molybdenum plate 116 to the stamping 175. Additional heat dissipation may be accomplished by providing stamping 175 with fins 180 extending upwardly from the top of the stamping. The outermost one of fins 180 are each provided with notches 182 to facilitate connection between the collector of the transistor on the die 114 and an external connecting bus (not shown).

The foregoing discloses an improved semiconductor package which has at its core an improved semiconductor module comprised of a semiconductor die mounted to, and supported from a supporting pad having the same thermal coefficient of expansion as the die. A ceramic die cover encapsulates the semiconductor die and not only serves to protect the die and dissipate the heat generated thereby but also serves to firmly secure the electrodes which extend through the die cover and to the die to protect the die against thermal and mechanical stresses. The ceramic die cover also serves to facilitate manufacturing by aligning the electrodes on the top of the semiconductor die and by supporting the electrodes during the solder bonding operation. The ceramic die cover serves these purposes with a minimum of stress on the module by a virtue of the small differences in thermal expansion between the die and the die cover. Further, the ability of the ceramic die cover to withstand high temperatures assures a minimum of outgassing or distortion at high process temperatures.

While only certain preferred features of the invention have been shown by way of illustration, many modifications and changes will occur to those skilled in the art. It is, therefore, to be understood, that the appended claims are intended to cover all such modifications
and changes as fall within the true spirit of the
invention.

Claims:

1.  A semiconductor module comprising:

a semiconductor die (14; 14'; 114) which embodies at least one semiconductor device;

a supporting pad (16; 16'; 116) of approximately the same thermal coefficient of expansion as said semiconductor die, said supporting pad bonded to said die to support said die and conduct heat therefrom;

a rigid, heat conductive electrically insulated shell (18; 18'; 118) having a recess (19; 19', 119) therein dimensioned to receive said semiconductor die when said shell is secured to said supporting pad to overlie said die and thus sealably enclose said die, said shell having at least one metallized solder coated passageway (21a, 22a; 53; 21a', 22a'; 121a, 121b) therethrough which is in communication with said shell recess; and

at least one electrically conductive member (22, 24; 22', 24';173a, 173b) disposed through said shell passageway for contact with said semiconductor die, the portion (22a, 24a; 52; 25a', 25b'; 125a, 125b) of said conductive member contiguous with said metallized and solder-coated shell passages being itself solder-coated for solder bonding to said shell so that said shell absorbs shock and thermal stress as applied to said conductive member to protect said die during and after manufacturing to facilitate semiconductor module assembly.

2.  The semiconductor module according to claim 1 wherein said supporting pad is a molybdenum plate (16; 16'; 116) having a solder-coated upper surface for solder bonding to said semiconductor die (14; 14'; 114).

3. The semiconductor module according to claim 2 wherein said rigid, heat conductive, electrically insulating shell is a ceramic die cover (18; 18'; 118) having metallized and solder-coated lower edges (20) for solder bonding to said molybdenum plate (16; 16'; 116) to hermetically seal said die (14; 14'; 114) within the recess (19; 19'; 119) of said ceramic die cover (18; 18'; 118).

4. The semiconductor module according to claim 2 wherein said rigid, heat conductive, electrically insulating shell comprises a ceramic die cover (18; 18'; 118) whose lower edges are bonded by a polymer sealant to said molybdenum plate (16; 16'; 116) to seal said semiconductor die (14; 14'; 114) within the recess (19; 19'; 119) of said die cover (18; 18'; 118).

5. The semiconductor module according to anyone of the claims 1 to 4 wherein said electrically conductive member (22, 24) comprises a metal strip having a solder-coated finger (22a, 24a) disposed through said metallized, solder-coated passage in said shell to contact said semiconductor die and make electrical connection therewith.

6. The semiconductor module according to anyone of the claims 1 to 4 wherein said electrically conductive member (12', 24!; 173a, 173b) is a pin (25a', 25b'; 125a, 125b) swaged through said passageway (21a', 21b'; 121a, 121b) in said heat conductive shell (18'; 118), said pin being solder-coated to enable a solder bond with said metallized and solder-coated shell passageway.

7.  The semiconductor module according to anyone of the claims 1 to 6 further including:

a heat conductive base plate (30; 30');

an insulating subplate (28; 28') interposed between said supporting pad (16; 16') and said base plate (30; 30') for insulating said supporting pad from said base plate and for carrying heat from said supporting pad to said base plate; and

an exterior shell (32; 32') having a recess (34; 34') therein for receiving said module (12a, 12b; 12a'), said shell (32; 32') having passageways (36; 36') therethrough to enable said electrically conductive members (22, 24, 26; 22', 24', 26') to extend beyond said exterior shell.

8.  A semiconductor package comprising:

a heat conductive base plate (30; 30');

a heat conductive electrically insulated subplate (28; 28') bonded to said base plate so as to be in face-to-face relationship therewith and supported thereby;

a first electrode (26; 26') bonded to said insulated subplate,

a semiconductor die (14; 14') embodying at least one semiconductor device;

a supporting pad (16; 16') of approximately the same thermal coefficient as said semiconductor die, said supporting pad bonded to and interposed between said insulated subplate and said semiconductor die;

a rigid heat conductive, electrically insulating shell (18; 18') having a recess (19; 19') therein dimensioned to receive said die, said shell having a metallized edge (20) for setting upon said supporting pad (16) when said heat conductive, electrically insulating cover (18; 18') is fastened to said supporting pad (16; 16') to overlie said die (14; 14') and said supporting pad;

said shell (18; 18') having at least one metallized and solder-coated passageway (21a, 21b; 53; 21a', 22a') extending therethrough in communication with said recess (19; 19');

at least one electrode (22, 24; 22', 24') extending through said shell passageway for physically contacting said semiconductor die (14; 14') to make electrical connection therewith, said electrode having a solder-coated portion (22a, 24a; 52; 25a', 25b') in contact with said metallized and solder-coated shell passageway (21a, 21b; 53; 25a', 25b') for solder bonding to said shell (18; 18') so that said shell absorbs shock and thermal stress as applied to said electrode so as to protect said die (14; 14');

an outer housing (32; 32') having a recess (34; 34') dimensioned to receive said shell and having a passageway (36) therethrough to receive said electrode (22, 24; 22', 24') when said outer housing (32; 32') is fastened to said base plate (30, 30') to overlie said shell; and

a heat conductive sealant (45) for filling said recess (34; 34') to seal and secure said shell (18; 18') and said supporting pad (16; 16') within said recess (34; 34') and to block any dielectric leakage paths and conducting any heat dissipated by said shell and said supporting pad.

9. The semiconductor package according to claim 8 wherein said base plate (30; 30') comprises a copper pad.

10. The semiconductor package according to claim 8 or 9 wherein said heat conductive, electrically insulated subplate (28; 28') comprises a ceramic pad having metallized top and bottom surfaces.

11. The semiconductor package according to anyone of the claims 8 to 10 wherein said supporting pad comprises a molybdenum plate (16; 16') having a solder-coated upper surface and wherein said shell comprises a ceramic die cover (18; 18') having metallized, solder-coated lower edges for solder bonding to said metallized molybdenum plate (16; 16') to hermetically seal said die (14; 14') within the recess (19; 19') of said ceramic die cover.

12. The semiconductor package according to anyone of the claims 8 to 10 wherein said supporting pad comprises a molybdenum plate (16; 16') and wherein said shell comprises a ceramic die cover (18; 18') having lower edges bonded to said molybdenum plate by polymer sealant to overlie said die.

13. The semiconductor package according to anyone of the claims 8 to 12 wherein said outer housing comprises a plastic shell (32; 32').

14. A semiconductor package comprising:
an electrically conductive heat dissipative base plate (30);
a heat conductive, electrically insulating subplate (28) having a metallized and solder-coated top and bottom surfaces, said bottom metallized surface of said insulating subplate solder bonded to said base plate (30) so as to be supported therefrom;
a first electrode (26) having a solder-coated portion (26b) solder bonded to said top metallized surface of said insulating subplate (28);
a first semiconductor die (14) embodying a Darlington transistor thereon, said Darlington transistor having first and second stage transistor elements;

an electrically conductive supporting pad (16) having a thermal co-efficient of expansion substantially similar to that of said first semiconductor die (14), said supporting pad having bottom and top solder-coated surfaces which are solder bonded to said first electrode (26) and to said semiconductor die (14), respectively, to provide a conductive path between the collector of said second stage transistor element and said supporting pad;

a rigid, heat conductive, electrically insulating shell (18) having a recess (19) therein dimensioned to receive said die (14), said shell (18) having metallized lower edges (20) adjacent to said recess (19) for solder bonding to said supporting pad (16) so as to overlie said die (14), said shell having first (21a), second (53), and third (21b) metallized, solder-coated passages therethrough in communication with said recess (19);

a second electrode (22) having first (22a) and second (48) solder-coated fingers co-extensive therewith, said first electrode finger (22a) extending through said first shell passageway (21a) to contact said die (14) and make electrical connection with the base of said first stage transistor element, said first electrode finger (22a) being solder bonded to said shell (18) so that shock and thermal stresses applied to said second electrode (22) are transmitted through said shell (18) to said base plate (30);

an electrically conductive pin (52) disposed through said second shell passageway (53) for electrical connection to the emitter of said first stage transistor element, said pin (52) being solder-coated for electrical bonding to said shell (18);

a second semiconductor die (50) embodying a diode thereon, said second die interposed between said second finger (48) of said second electrode (22) and said electrically conductive pin (52) such that the anode and cathode of said diode embodied on said die (50) are electrically connected to said pin and said second finger (48) of said second electrode (22), respectively;

a third electrode (24) having first (24a) and second (57) solder-coated fingers, said first solder-coated finger (24a) extending through said third shell passageway (21b) to contact said first semiconductor die (14) and electrically connect with the emitter of said second stage transistor element, said first finger (24a) of said third electrode (24) being solder bonded to said shell (18) so that shock and thermal stress is applied to said third electrode (24) are carried by said shell (18) to said base plate (30);

a third semiconductor die (56) embodying a diode thereon, said third semiconductor die interposed between said electrically conductive subplate (28) and said second finger (57) of said third electrode (24) so that the anode and cathode of said diode are connected to said second finger (57) of said third electrode (24) and said subplate (28), respectively; and

an outer housing (32) having a recess (34) therein dimensioned to receive said shell (18) and said subplate (28) when said shell is fastened to said base plate.

15. The semiconductor package according to claim 14 wherein said heat conductive, electrically insulating subplate (28) comprises a ceramic substrate.

16. The semiconductor package according to claim 14 or 15 wherein said supporting pad (16) comprises a molybdenum substrate.

17. The semiconductor package according to anyone of the claims 14 to 16 wherein said rigid, heat conductive, electrically insulating shell (18) comprises a ceramic die cover.

0116289

18.  A semiconductor module for surface mounting on a printed circuit board or the like comprising:

a semiconductor die (114) embodying a semiconductor device thereon;

an electrically conductive mounting pad (116) having approximately the same thermal coefficient of expansion as said die, said mounting pad having a solder coating on its bottom surface to facilitate solder bonding to the circuit board (113) and said mounting pad having a solder coating on its top surface to facilitate solder bonding to said die (114) so that said mounting pad (116) is interposed between circuit board (113) and said die (114);

a rigid heat conductive, electrically insulating shell (118) having a recess (119) therein dimensioned to receive said die, said shell having metallized and solder-coated edges for solder bonding to said mounting pad (116) to overlie said die (114), said shell (118) further having at least one passageway (121a, 121b) into said recess (119), the contact surfaces of said passageway being metallized and solder-coated;

at least one conductive member (125a, 125b) swaged through said passageway (121a, 121b) of said shell (118) so as to protrude from said shell for contact with said die (114), said conductive member having a solder-coated tip for solder bonding to said die (114) and having a solder coating on the conductive member surfaces contiguous with the contact surfaces of said shell passageway (121a, 121b) for solder bonding thereto, said conductive member (125a, 173a, 125b, 173b) extending from said shell (118) to the circuit board surface (113) for electrical connection therewith.

19.  The semiconductor module according to claim 18 wherein said conductive member (125a, 125b) extends through the circuit board.

20. The semiconductor module according to claim 19 further including a "U" shaped heat conductive member (175) having its upper interior surface electrically bonded to said electrically conductive mounting pad (116) of said semiconductor module (112a) when inverted, said conductive member having a pair of legs (176a, 176b) each extending through said circuit board for electrical connection therewith and said heat conductive member (175) having at least one outwardly extending fin (180) for radiating heat.

FIG.1

FIG.2

1/3

0116289

FIG.3

FIG.4

FIG.5

FIG.6

FIG.7

FIG.8